# EUROPEAN PATENT SPECIFICATION

(11) **EP 1 793 007 B1**
(45) Date of publication and mention of the grant of the patent: **18.03.2009**
(21) Application number: 06025041.2
(22) Date of filing: 04.12.2006
(51) Int. Cl.: C22C 14/00, C01B 3/00, C22B 9/00, C22B 9/16, C22C 1/00, C30B 11/00, C30B 13/00, C30B 30/04, C30B 35/00, H01M 4/02, C30B 28/00

(54) **Method for producing unidirectionally solidified hydrogen storage alloy**
Verfahren zur Herstellung einer gerichtet erstarrten Wasserstoff-Speicher-Legierung
procédé de production d'un alliage de stockage d'hydrogene solidifié directionnellement

(30) Priority: 05.12.2005 JP 2005350250
(43) Date of publication of application: 06.06.2007
(73) Proprietor: THE JAPAN STEEL WORKS, LTD., Tokyo (JP)
(72) Inventor: Ito, Hideaki, Muroran-shi Hokkaido (JP); Takahashi, Toshio, Muroran-shi Hokkaido (JP); Yamada, Hitohisa, Muroran-shi Hokkaido (JP); Kabutomori, Toshiki, Muroran-shi Hokkaido (JP)
(74) Representative: Grünecker, Kinkeldey, Stockmair & Schwanhäusser Anwaltssozietät

(56) References cited:
- GB-A- 827 676
- JP-A- 6 212 311
- US-A- 3 549 353
- US-A1- 2004 060 388

## Description

This application claims priority from Japanese Patent Application No. 2005-350250, filed on December 5, 2005.

### BACKGROUND OF THE INVENTION

### 1. Field of the Invention

The invention relates to a hydrogen storage alloy which can reversibly absorb and release hydrogen and is used in a hydrogen storage tank, a hydrogen feed system for fuel cell, a hydrogen refining and recovering system, a hydrogen absorption material for hydrogen gas actuator and an electrode material for nickel-hydrogen battery. This invention can also be applied to a hydrogen storage tank that stores and feeds hydrogen in a temperature range from room temperature to 100°C.

### 2. Description of the Related Art

Hitherto, when hydrogen is stored and transported, a hydrogen cylinder in which hydrogen gas is compressed and filled or liquid hydrogen has been used. Recently, a technology that uses a hydrogen storage alloy is gathering attention. A hydrogen storage alloy can store hydrogen of a volume corresponding to 1000 times a volume thereof and can reversibly release. Accordingly, a volume space necessary for storing a definite amount of hydrogen is smaller in comparison with the case where a high-pressure cylinder or liquid hydrogen is used. Accordingly, hydrogen can be compactly stored. Furthermore, the hydrogen storage alloy can reversibly absorb and release hydrogen at ambient temperature under pressure of 10 atm or less. Accordingly, it can be said a hydrogen storage method that neither necessitates cooling to a very low temperature like liquid hydrogen nor pressurizing by use of a compressor like a high-pressure cylinder and a material that can realize safe and convenient storage of hydrogen. Furthermore, application systems such as a chemical heat pump and a heat transportation system that make use of a reaction heat at the time of absorption and release of hydrogen and an actuator that makes use of pressure difference at the time of absorption and release of hydrogen are considered and some of these are put into practical use.

When the hydrogen storage alloy is applied to various application fields, how much hydrogen can be reversibly absorbed and released is considered most important. As the hydrogen storage alloys that have been put into practical use, an AB₅ type alloy typical in LaNi₅ and an AB₂ type alloy typical in TiMn_{1.5} and TiCr₂ are known. However, since a reversible absorption/release amount thereof is 2% by weight or less, a material larger in the storage amount of hydrogen is demanded from a system user side. On the other hand, vanadium metal, as a simple material, can reversibly absorb and release hydrogen. In the case of simple vanadium metal, it is necessary to vacuum at a high temperature of 400°C or more to let absorb hydrogen at first (activate) and furthermore to apply hydrogen pressure of several tens atm. Accordingly, it is difficult to put into practical use for a system that is used in room temperature and under low pressure. In order to improve the problem, Ti-Cr-Mn system alloys and Ti-Cr-V system alloys that have a BCC structure that is same in the crystal structure with that of vanadium metal have been developed. In the alloys, the maximum hydrogen storage amount is close to 4% by weight similarly to the vanadium metal. However, a hydrogen amount that can be reversibly absorbed and released at ambient temperature is only 2.5% by weight. In order to improve this, various researches and developments have been forwarded.

The hydrogen storage alloys having the BCC structure, unlike intermetallic compounds that have a fixed value of metal atom ratio like existing alloys typical in LaNi₅, are materials in which constituent elements are in solid solution at an arbitrary metal atom ratio. Usually, the hydrogen storage alloy having the BCC structure is produced in such a manner that raw material metals are blended and melted at a predetermined ratio, followed by casting in a mold, further followed by applying heat treatment to an ingot to homogenize a crystal structure and components.

Hitherto, as a method of slowly lowering a temperature from a molten state during production of a hydrogen storage alloy to solidify, a method such as disclosed in JP-A-60-135538, in which a La-Ni system alloy is grown into an aligned structure by a directional solidification process or a method such as proposed in JP-A-07-157833, in which a Ti-Cr system alloy, while allowing growing unidirectionally, is solidified to carry a hydrogen-storing composition with a non-hydrogen-storing composition is known. However, in the methods, in order to inhibit the hydrogen storage alloy from pulverization, two different kinds of phases of a hydrogen-storing composition and a non-hydrogen-storing composition are tried to obtain as an aligned structure. However, there is a problem in that when the non-hydrogen-storing composition is precipitated, the material as a whole is deteriorated in a hydrogen storage amount. On the other handy, according to JP-A-06-212311, a molten metal of a hydrogen storage alloy having a Laves phase structure of AB₂ type is unidirectionally solidified to form an electrode material of single phase, and thereby a phase other than an effective alloy phase is removed.
From US 3,549,359 a method is known, in which the crucible walls are cooled by cooling fluid which is continuously circulated in the walls. This prior art teaches to move coils relative to the crucible for the purpose of melting an alloy.
Furthermore, in JP-A-2003-277847, a method of solidifying a hydrogen storage alloy having a body-centered cubic structure (BCC structure) while gradually cooling at a cooling speed of 5°C/min or less or a method of accelerating homogenization of an alloy by a zone melting process is proposed. However, the method intends as well to reduce solidification/segregation and inclusions.

However, it is considered that, since the heat treatments in existing producing methods cannot achieve sufficient homogenization, the reversible hydrogen absorption and release characteristics that the alloy latently has cannot be exerted. In order to make the homogenization more complete, JP-A-2003-277847 proposes gradually cooling a molten metal at a cooling speed of 5°C/min or less. However, in the hydrogen storage alloys having the BCC structure, inclusion of impurity elements deteriorates the hydrogen storage characteristics. Accordingly, gaseous impurities such as oxygen, nitrogen and carbon are particularly demanded to reduce as low as possible. Normally, when a hydrogen storage alloy is melted, an oxide refractory crucible is used. Accordingly, when a molten alloy is gradually cooled to solidify, since a time during which the molten metal in a liquid state is in contact with the crucible becomes longer, oxygen from the refractory crucible comes in the molten alloy. Thus, an improvement effect is not sufficiently obtained. On the other hand, JP-A-2003-277847 discloses as well a method due to a floating zone melting process, in which a refractory crucible is not used. The floating zone melting process is a process where, owing to the surface tension of a liquid in a molten region, solid portions up and down are joined. When a sample size is made larger, since the surface tension of the liquid cannot withstand a self-weight, the continuity of the sample is discontinued. Accordingly, the method is a method that cannot be expanded in scale to apply industrially.

### SUMMARY OF THE INVENTION

The invention relates to a producing method according to claim 1 of a hydrogen storage alloy having a BCC structure, and intends to grow, without including impurities from a refractory material, a large unidirectionally grown grains to produce in an industrial scale a BCC alloy that is excellent in the hydrogen storage characteristics such as an increase in a reversible absorption and release amount of hydrogen, the flattening of a plateau and an improvement in the durability.

That is, among present inventions, according to a first aspect of the invention, there is provided a method of producing a hydrogen storage alloy according to claim 1.

According to the first aspect of the invention, a high melting point hydrogen storage alloy having a BCC structure can be melted without coming into contact with a refractory and thereby impurity elements such as Ca, Mg, Al and Si derived from the refractory can be inhibited from contamination. In particular, oxygen that deteriorates the hydrogen storage characteristics of the alloy having a BCC structure can be inhibited from contaminating from the refractory to increase an oxygen content in the alloy. The smaller the oxygen content in the hydrogen storage alloy is, the more desirable, for instance, 500 ppm or less being preferable.

Furthermore, when the molten alloy is cooled from one side to slowly unidirectionally solidify, homogeneous crystal grains close to single crystal can be obtained and an aggregate of large grains having directionality in the grain growth owing to the unidirectional solidification can be obtained.

According to a further aspect of the invention, the metal crucible comprises copper.

In the further aspect of the invention, when a refractory crucible is avoided to use and a crucible made of metal such as copper is used while cooling with water to melt an alloy, the impurities, in particular, oxygen can be assuredly inhibited from contaminating from the refractory crucible into the hydrogen storage alloy.

According to a further aspect of the invention, a speed of the unidirectional solidification is set at a moving speed of a solid-liquid interface in a range of 10 to 200 mm/hr.

In the further aspect of the invention, when the unidirectional solidification speed is set at an appropriate moving speed of solid-liquid interface, the crystallinity can be improved and the impurities can be drastically reduced, and thereby the hydrogen storage characteristics can be largely improved.

According to a further aspect of the invention, the speed of the unidirectional solidification process is set at the moving speed of a solid-liquid interface in a range of 12 to 60 mm/hr.

According to a further aspect of the invention, the hydrogen storage alloy is melted and unidirectionally solidified in a vacuum or an inert gas atmosphere.

In the invention, since the refractory crucible is not used, oxygen is inhibited from contaminating from the crucible into the alloy. On the other hand, as a source of oxygen in the hydrogen storage alloy as an impurity, oxygen present in an atmosphere of a melting furnace can be considered as well. In the sixth aspect of the invention, a process from melting to solidification is carried out in a vacuum or inert gas atmosphere, and, thereby, oxygen is as far as possible inhibited from contaminating from the atmosphere into the hydrogen storage alloy. Thereby, oxygen contained in the produced hydrogen storage alloy can be suppressed to a sum total of oxygen amounts contained in melt raw materials of the respective alloy components. Accordingly, the characteristics deterioration can be suppressed to the minimum level.

According to a further aspect of the invention, the unidirectional solidification process is carried out by a cold crucible induction melting process.

In the further aspect of the invention, in a state where a contact with a water-cooled crucible is suppressed minimum by use of an electromagnetic force, a hydrogen storage alloy can be melted and furthermore a melting raw material can be continuously supplied and a solidified alloy can be readily drawn.

According to claim 1, the unidirectional solidification is carried out by disposing a water-cooled metallic crucible along an axial direction inside of an induction heating coil, and moving the metallic crucible relatively to the induction heating coil in a direction opposite to a solidification direction.

When the water-cooled metal crucible is moved relatively to the induction heating coil in an axial direction, while controlling the moving speed of the solid-liquid interface, the unidirectional solidification can be applied.

An aggregate structure of large grains that less contain the impurities such as oxygen that deteriorates the hydrogen storage characteristics, are homogeneous and have the directionality in the grain growth can be obtained. Thereby, excellent hydrogen storage characteristics can be exerted.

As mentioned above, according to the producing method of a hydrogen storage alloy of the invention, since a hydrogen storage alloy having a body-centered cubic structure as a crystal structure is melted without using a refractory crucible and a molten alloy thereof is solidified by the unidirectional solidification process. Therefore, impurities can be suppressed as low as possible and large grains having the directionality can be obtained. Accordingly, it is possible to industrially produce a BCC structured hydrogen storage alloy that is larger in-the hydrogen storage-amount than that of an alloy produced according to an existing method and smaller in the plateau gradient and the hysteresis and excellent in the durability.

The hydrogen storage alloy produced according to a producing method of the invention has a body-centered cubic structure as the crystal structure, has a large hydrogen storage amount and excellent plateau characteristics and the durability.

### BRIEF DESCRIPTION OF THE DRAWINGS

Fig. 1 is a cross sectional diagram of a cold crucible furnace used in a producing method of one embodiment of the invention;
Fig. 2 is a substitution photograph for a drawing showing a structure of a hydrogen storage alloy obtained according to example 1 of the invention;
Fig. 3 is a substitution photograph for a drawing showing a structure of a hydrogen storage alloy obtained according to example 4 of the invention;
Fig. 4 is a diagram showing hydrogen equilibrium pressure-composition-isotherms of hydrogen storage alloys in examples and comparative examples of the invention;
Fig. 5 is a diagram showing maximum hydrogen storage amounts of hydrogen storage alloys in examples and comparative examples of the invention; and
Fig. 6 is a diagram showing remaining ratio of hydrogen transfer amounts due to repetition of hydrogen absorption and release of hydrogen storage alloys in examples and comparative examples of the invention.

### DETAILED DESCRIPTION OF THE PREFERRED EMBODIMENTS

Embodiments of the invention will be described below.

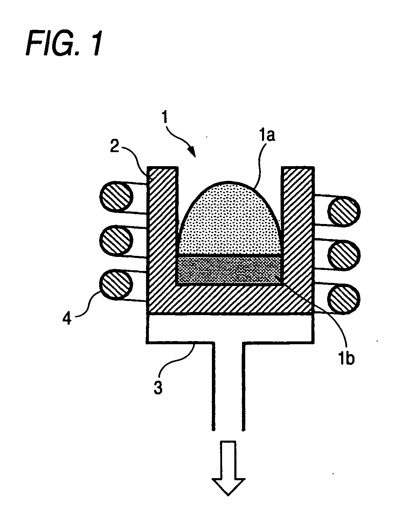

Fig. 1 shows a cold crucible furnace that is used in a producing method according to the invention of a hydrogen storage alloy. In the melting furnace, a water-cooled crucible 2 made of copper is disposed on an elevatable crucible table 3. In an external periphery of the water-cooled crucible 2, induction heating coil 4 is disposed and a metal material accommodated in the water-cooled crucible 2 can be melted by induction heating.

One embodiment of a producing method of the invention of a hydrogen storage alloy, which uses the cold crucible furnace, will be described below.

A hydrogen storage alloy raw material 1 such as Ti-Cr-Mn system alloy or Ti-Cr-V system alloy having a BCC structure is prepared at a desired component ratio, accommodated in the water-cooled crucible 2, followed by oscillating the induction heating coil 4 to melt the hydrogen storage alloy raw material 1 in the water-cooled crucible. At that time, the hydrogen storage alloy raw material 1 is disposed under a vacuum atmosphere or under an inert gas atmosphere. By the melting, a molten metal 1a of the hydrogen storage alloy is obtained. In the next place, a bottom portion of the water-cooled crucible 2 is water-cooled to unidirectionally solidify the hydrogen storage alloy melt la down up from the bottom side to gradually obtain a unidirectionally solidified alloy 1b. At this time, the crucible table 3 is lowered to move the water-cooled crucible 2 in a direction opposite to a solidification direction relative to the induction heating coil 4 to control the solidification speed at a moving speed of the solid-liquid interface from 10 to 200 mm/hr. When the moving speed of a solidification interface exceeds 200 mm/hr, in an obtained alloy, the homogeneity cannot be improved, grain growth and reduction of the impurities cannot be sufficiently achieved. Accordingly, an advantage of the characteristics improvement cannot be obtained. Furthermore, when the moving speed of the solidification interface is less than 10 mm/hr, owing to the equilibrium partitioning between a solid phase and a liquid phase, an alloy composition tends to vary and it takes a long time to produce an alloy to remarkably lower the production efficiency. Accordingly, the moving speed of solid-liquid interface is shown as a desirable range. In view of a balance between the efficiency when the alloy is produced and the hydrogen storage characteristics of the obtained alloy, the moving speed of the solid-liquid interface is preferably set at 12 mm/hr at the minimum and 60 mm/hr at the maximum. According to the above process, the hydrogen storage alloy 1b can be efficiently produced. Furthermore, when grains are grown in one direction like this, impurity elements in the melt, which remains in a solid phase during the rapid solidification, can be exhausted in a liquid phase and thereby an amount of impurities in the produced alloy can be reduced. In the hydrogen storage alloy having a BCC structure, the number of hydrogen occupation sites where hydrogen can be stable in the alloy is larger than other alloys. Accordingly, a large hydrogen storage amount is exhibited. However, owing to the deterioration of the crystallinity and existence of impurities, energy levels of the hydrogen occupation sites are broadened, resulting in a decease in the hydrogen absorption amount, an increase in the plateau gradient and an increase in the hysteresis. The invention can improve the hydrogen storage characteristics of the hydrogen storage alloy having a BCC structure and has an effect as well on the alloy deterioration observed as a decrease in the hydrogen storage amount when an absorption/release of hydrogen is repeated.

The hydrogen storage alloy obtained according to the above process can be obtained as an aggregate of large grains that less contain the impurities, in particular, oxygen, are homogeneous in the structure and have the directionality in the grain growth can be obtained. The alloy is large in the reversible absorption and release amount of hydrogen, flat in the plateau and excellent in the durability, as well.

### (Example 1)

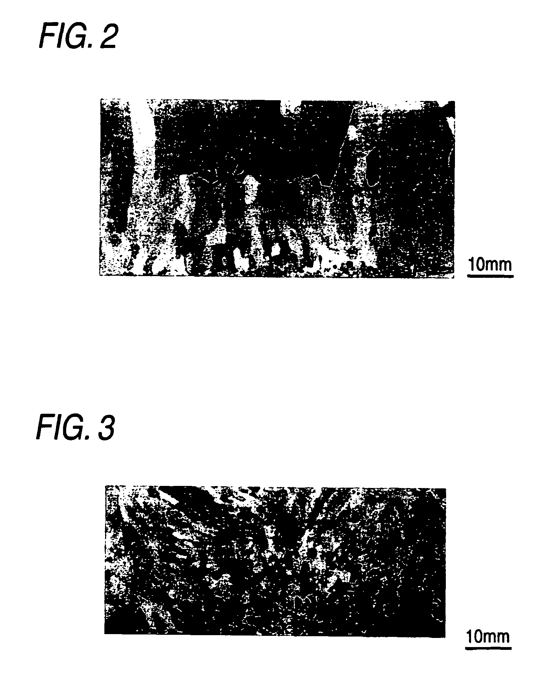

In the beginning, 3 kg of raw material metals is blended so that a composition may be Ti: Cr: V = 7.5: 13.5: 79 by atomic ratio and the blend is primarily melted with an intention of alloying of raw materials with a water-cooled crucible having a diameter of 100 mm under anAr gas atmosphere in a cold crucible furnace shown in Fig. 1. In order to promote the homogenization of alloy components, a primarily molten ingot is cut into substantially 20 mm cubes and the cubes are melted again with a water-cooled crucible having a diameter of 80 mm under an Ar gas atmosphere in the cold crucible furnace. When all material in the water-cooled crucible is melted, the water-cooled crucible is lowered in an arrow mark direction shown in Fig. 1 at a speed of 12 mm/hr to allow unidirectionally solidifying at the moving speed of solid-liquid interface of 12 mm/hr. After cooling to room temperature, an ingot is taken out. A vertical cross sectional structure of the ingot is shown in Fig. 2. In an upward direction from a bottom portion of the crucible, large grains having a width of 3 to 5 mm are grown. That is, a unidirectionally grown structure can be obtained.

### (Example 2)

Similarly to example 1, a primary melting and a re-melting are carried out and thereafter a water-cooled crucible is lowered at a speed of 30 mm/hr to unidirectionally solidify at a moving speed of the solid-liquid interface of 30 mm/hr. After cooling to room temperature, an ingot is taken out. When observing a vertical cross sectional structure of the ingot, large grains having a width of 3 to 4 mm are grown in an upward direction from a bottom portion of the crucible. That is, a unidirectionally grown structure can be obtained.

### (Example 3)

Similarly to example 1, a primary melting and are-melting are carried out and thereafter a water-cooled crucible is lowered at a speed of 60 mm/hr to unidirectionally solidify at a moving speed of the solid-liquid interface of 60 mm/hr. After cooling to room temperature, an ingot is taken out. When observing a vertical cross sectional structure of the ingot, grains having a width of substantially 2 mm are grown in an upward direction from a bottom portion of the crucible. That is, a unidirectionally grown structure can be obtained.

### (Example 4)

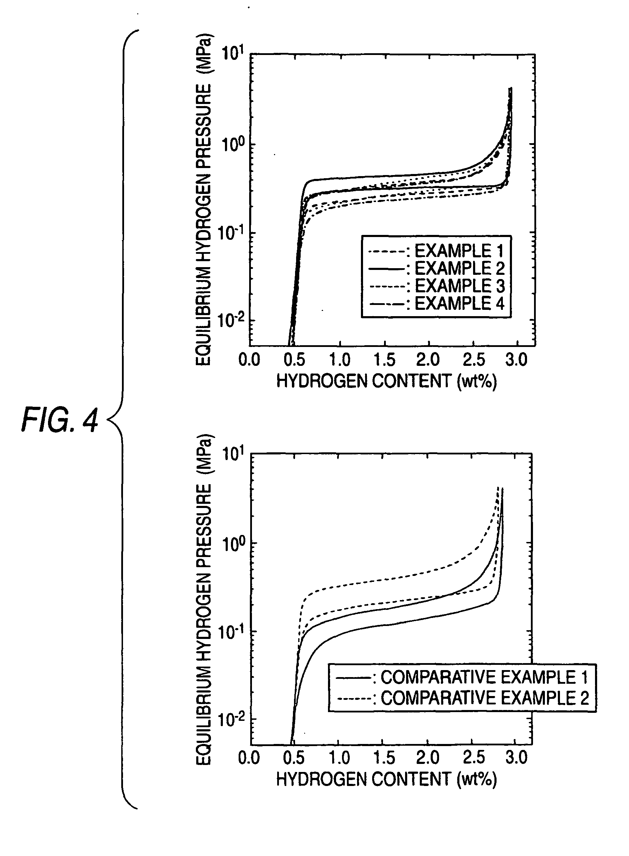

Similarly to example 1, a primary melting and are-melting are carried out and thereafter a water-cooled crucible is lowered at a speed of 120 mm/hr to unidirectionally solidify at a moving speed of the solid-liquid interface of 120 mm/hr. After cooling to room temperature, an ingot is taken out. A vertical cross sectional structure of the ingot is shown in Fig. 4. When observing a vertical cross sectional structure of the ingot, grains are grown in an upward direction from a bottom portion of the crucible in some parts. However, magnitude of grains is substantially 1 to 2 mm. That is, large grain growth is not achieved.

### (Comparative Example 1)

Raw material metals of 50 g is blended so that a composition ratio of Ti: Cr: V may be 8: 13: 79 by atomic ratio, followed by melting in an arc melting furnace with a water-cooled hearth made of copper in an Ar gas atmosphere. After the melting, a molten metal is cooled as it is to room temperature in the water-cooled hearth.

### (Comparative Example 2)

Raw material metals of 10 kg are blended so that a composition ratio of Ti: Cr: V may be 7.5: 13.5: 79 by atomic ratio, followed by melting by the high frequency induction heating with a calcia crucible in an Ar gas atmosphere. Amolten metal is poured into a 17 mm thick steel mold in an Ar gas atmosphere and cooled to room temperature, followed by taking out of the melting furnace.

Alloy components of the respective alloys obtained in the examples 1 through 4 and comparative examples 1 and 2, Ti, Cr and V and impurities of O, N and C are analyzed. Results thereof are shown in Table 1. In the melting process where the refractory crucible is not used like in examples 1 through 4 and comparative example 1, oxygen is less contained, and an amount of impurities in the alloy can be suppressed low. In particular, in examples 1 through 3, since contents of O and C are less than other alloys, it is shown that, by conducting the unidirectional solidification, the impurities in the alloys can be reduced.

Further, in examples 1 through 3 and comparative example 1, alloys are melted and produced so as to obtain the same composition. Here, in examples 1 through 3, Ti is less contained than other alloys. Accordingly, it is found that when the solidification speed is slowed the alloy composition varies.

Then, the hydrogen storage characteristics of the alloys are measured and results are shown in Fig. 4. From each of the alloy ingots of examples 1 through 4 and comparative examples 1 and 2, a sample of substantially 5 g is cut out. The sample is introduced into a hydrogenation characteristics measurement equipment and a sample vessel is vacuumed with a rotary vacuum pump, followed by cooling the sample vessel to 5°C in a water bath, further followed by adding hydrogen gas at 4.5 MPa to activate. After sufficient absorption of hydrogen by the activation, followed by vacuuming at 100°C for 1 hour, and with this state as an original point, a hydrogen equilibrium pressure-composition-isotherm is measured. In Fig. 4, PCI curves at 20°C are shown of the respective samples. An arc-melted sample according to comparative example 1, in spite of a low content of oxygen that is the impurity, shows a large plateau gradient and hysteresis. Comparative example 2 shows large plateau gradient and hysteresis similarly to comparative example 1. Furthermore, because of the use of the refractory crucible, oxygen is contained much, resulting in lowering a hydrogen storage amount.

Example 2 is most abundant in the hydrogen storage amount, slight in the plateau gradient and very small in the hysteresis, that is, very excellent in the characteristics. Example 4 is, though slightly larger than example 1 in the hysteresis, excellent in the flatness of the plateau and has a larger hydrogen storage amount than comparative example 1.

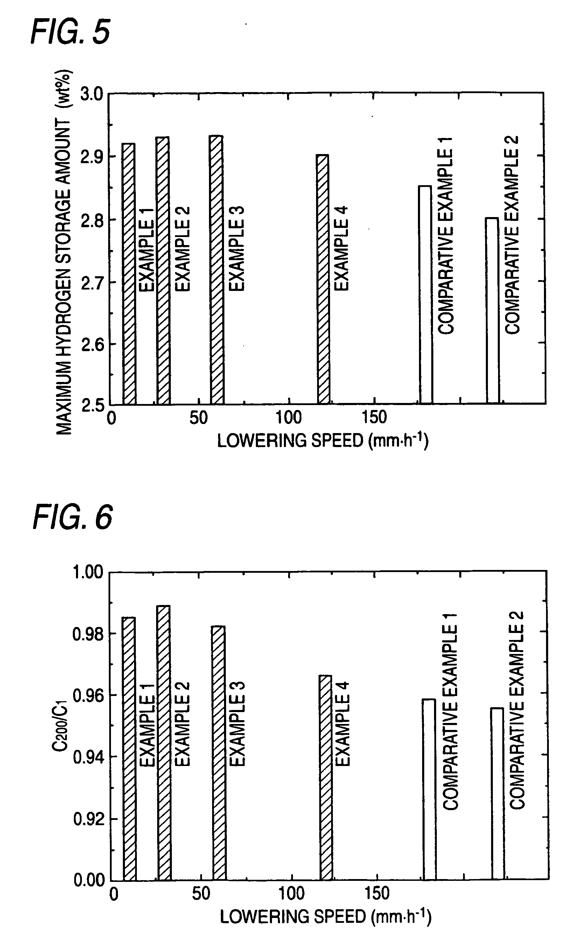

In the next place, the maximum hydrogen storage amounts when hydrogen is absorbed with the vacuuming at 100°C for 1 hour as an original point are shown in block in Fig. 5. It is found that, in comparison with comparative examples 1 and 2, examples 1 through 4 where grains are grown according to the unidirectional solidification show larger hydrogen storage amount.

Fig. 6 shows remaining ratio of hydrogen transfer amount when absorption and release of hydrogen is repeated of the alloy samples. A vertical axis shows C₂₀₀/C₁ that is a value obtained by dividing a hydrogen transfer amount after 200 cycles by a hydrogen transfer amount at an initial time and shows a ratio at which the hydrogen storage amount of the initial alloy is maintained after 200 cycles. In comparison with comparative examples 1 and 2, in examples 1 through 4 where grains are grown by conducting the unidirectional solidification, all samples are small in the degradation of the hydrogen storage amount. In particular, in examples 1 through 3 where coarse grains are observed grown, excellent repetition durability is shown.

In the above, the invention has been described with reference to the embodiments and examples. However, the invention is not restricted to the content of the description and can be appropriately modified within a range that does not deviate from the scope of the invention.

For example, in the embodiments, the hydrogen storage alloy is melted by use of the electromagnetic force. However, as a method that, without using a refractory, industrially melts a metal, an arc melting process that uses a water-cooling hearth and an electron beam melting process can be cited. The melting processes can be applied as well when the unidirectional solidification is appropriately carried out thereafter. That is, as far as the refractory crucible is not used, the melting process is not particularly restricted.

Further, in the embodiments, the unidirectional solidification is applied when the water-cooled metal crucible is moved relatively to the induction heating coil in the axial direction. However, as far as the crucible and the induction heating coil are movable relatively, either one of these or both thereof may be moved to change relative position.

**[Table 1]**

| Sample | Metal Atom Ratio (at%) | | | Impurity Element (ppm) | | |
|---|---|---|---|---|---|---|
| | Ti | Cr | V | O | N | C |
| Example 1 | 5.88 | 13.44 | 80.68 | 253 | 123 | 40 |
| Example 2 | 5.19 | 12.96 | 81.85 | 294 | 132 | 30 |
| Example 3 | 5.30 | 12.60 | 82.10 | 281 | 125 | 60 |
| Example 4 | 7.22 | 13.56 | 79.22 | 338 | 133 | 190 |
| Comparative Example 1 | 8.11 | 12.25 | 79.46 | 633 | 250 | 120 |
| Comparative Example 2 | 7.32 | 13.56 | 79.11 | 3,340 | 181 | 160 |

## Claims

1. A method of producing a hydrogen storage alloy, comprising:
melting a hydrogen storage alloy (1) having a body-centered cubic crystal structure in a water-cooled metal crucible (2) without using a refractory crucible; and
solidifying a molten alloy (1a) by a unidirectional solidification process and by disposing the water-cooled metallic crucible (2) along an axial direction inside of an induction heating coil (4), and moving the metallic crucible (2) relatively to the induction heating coil (4), or moving the induction heating coil (4) relatively to the metallic crucible (2), or moving both (2,4) relatively to one another, in a direction opposite to a solidification direction.

2. The method of producing a hydrogen storage alloy according to claim 1,
wherein the metal crucible (2) comprises copper.

3. The method of producing a hydrogen storage alloy according to claim 1,
wherein a speed of the unidirectional solidification process is set at a moving speed of a solid-liquid interface in a range of 10 to 200 mm/hr.

4. The method of producing a hydrogen storage alloy according to claim 3,
wherein the speed of the unidirectional solidification process is set at the moving speed of a solid-liquid interface in a range of 12 to 60 mm/hr.

5. The method of producing a hydrogen storage alloy according to claim 1,
wherein the hydrogen storage alloy is melted and unidirectionally solidified in a vacuum or an inert gas atmosphere.

6. The method of producing a hydrogen storage alloy according to claim 1, wherein the refractory crucible is an oxide refractory crucible.

## Patentansprüche

1. Verfahren zum Erzeugen einer Wasserstoffspeicherlegierung, das umfasst:
Schmelzen einer Wasserstoffspeicherlegierung (1) mit einer kubisch- raumzentrierten Kristallstruktur in einem wassergekühlten Schmelztiegel (2) aus Metall ohne Verwendung eines feuerfesten Schmelztiegels; und
Erstarren einer geschmolzenen Legierung (1a) durch einen Prozess unidirektionaler Erstarrung sowie durch Anordnen des wassergekühlten metallischen Schmelztiegels (2) in einer axialen Richtung im Inneren einer Induktions-Heizspule (4) und Bewegen des metallischen Schmelztiegels (2) relativ zu der Induktions-Heizspule (4) oder Bewegen der Induktions-Heizspule (4) relativ zu dem metallischen Schmelztiegel (2) oder Bewegen beider (2, 4) relativ zueinander in einer Richtung entgegengesetzt zu einer Verfestigungsrichtung.

2. Verfahren zum Erzeugen einer Wasserstoffspeicherlegierung nach Anspruch 1, wobei der Schmelztiegel (2) aus Metall Kupfer umfasst.

3. Verfahren zum Erzeugen einer Wasserstoffspeicherlegierung nach Anspruch 1,
wobei eine Geschwindigkeit des Prozesses unidirektionaler Erstarrung auf eine Bewegungsgeschwindigkeit einer Fest-Flüssig-Grenzfläche in einem Bereich von 10 bis 200 mm/h eingestellt wird.

4. Verfahren zum Erzeugen einer Wasserstoffspeicherlegierung nach Anspruch 3, wobei die Geschwindigkeit des Prozesses unidirektionaler Erstarrung auf die Bewegungsgeschwindigkeit einer Fest-Flüssig-Phasengrenze in einem Bereich von 12 bis 60 mm/h eingestellt wird.

5. Verfahren zum Erzeugen einer Wasserstoffspeicherlegierung nach Anspruch 1, wobei die Wasserstoffspeicherlegierung in einem Vakuum oder einer inerten Gasatmosphäre zum Schmelzen gebracht und unidirektional erstarrt wird.

6. Verfahren zum Erzeugen einer Wasserstoffspeicherlegierung nach Anspruch 1, wobei der feuerfeste Schmelztiegel ein feuerfester Oxid-Schmelztiegel ist.

## Revendications

1. Procédé de production d'un alliage de stockage d'hydrogène, comprenant :
la fusion d'un alliage de stockage d'hydrogène (1) présentant une structure cristalline cubique centrée dans un creuset en métal refroidi à l'eau (2) sans utiliser un creuset réfractaire ; et
la solidification d'un alliage fondu (1a) par un procédé de solidification unidirectionnel et la disposition du creuset métallique refroidi à l'eau (2) le long d'une direction axiale à l'intérieur d'un serpentin de chauffage par induction (4), et le déplacement du creuset métallique (2) par rapport au serpentin de chauffage par induction (4), ou le déplacement du serpentin de chauffage par induction (4), par rapport au creuset métallique (2), ou le déplacement des deux (2,4) l'un par rapport à l'autre, dans une direction opposée à une direction de solidification.

2. Procédé de production d'un alliage de stockage d'hydrogène selon la revendication 1, dans lequel le creuset en métal (2) comprend du cuivre.

3. Procédé de production d'un alliage de stockage d'hydrogène selon la revendication 1, dans lequel une vitesse du procédé de solidification unidirectionnelle est fixée à une vitesse de déplacement d'une interface solide-liquide dans un intervalle de 10 à 200 mm/h.

4. Procédé de production d'un alliage de stockage d'hydrogène selon la revendication 3, dans lequel la vitesse du procédé de solidification unidirectionnelle est fixée à la vitesse de déplacement d'une interface solide-liquide dans un intervalle de 12 à 60 mm/h.

5. Procédé de production d'un alliage de stockage d'hydrogène selon la revendication 1, dans lequel l'alliage de stockage d'hydrogène est fondu et unidirectionnellement solidifié dans une atmosphère de vide ou dans une atmosphère de gaz inerte.

6. Procédé de production d'un alliage de stockage d'hydrogène selon la revendication 1, dans lequel le creuset réfractaire est un creuset réfractaire de type oxyde.
